# FASCICULE DE BREVET EUROPEEN

(11) **EP 3 191 857 B1**
(45) Date de publication et mention de la délivrance du brevet: **06.11.2019**
(21) Numéro de dépôt: 15763884.2
(22) Date de dépôt: 11.09.2015
(51) Int. Cl.: G01R 31/28

(54) **DISPOSITIF DE RÉGULATION DE LA TEMPÉRATURE D'UN MODULE DE PILOTAGE D'UN COMPOSANT ÉLECTRONIQUE**
VORRICHTUNG ZUR REGULIERUNG DER TEMPERATUR EINES MODULS ZUR ANSTEUERUNG EINER ELEKTRONISCHEN KOMPONENTE
DEVICE FOR REGULATING THE TEMPERATURE OF A MODULE FOR DRIVING AN ELECTRONIC COMPONENT

(30) Priorité: 11.09.2014 FR 1458538
(43) Date de publication de la demande: 19.07.2017
(73) Titulaire: Bibench Systems / Charlu SAS, 31200 Toulouse (FR)
(72) Inventeur: TIZON, André-Hubert, 31200 Toulouse (FR)
(74) Mandataire: Argyma
(86) Numéro de dépôt international: PCT/EP2015/070800
(87) Numéro de publication internationale: WO 2016/038176

(56) Documents cités:
- WO-A1-00/11487
- US-A- 4 379 259
- US-A- 5 021 732
- US-A- 5 126 656
- US-A- 6 091 062
- US-A1- 2011 256 774

## Description

### DOMAINE TECHNIQUE ET OBJET DE L'INVENTION

La présente invention se rapporte au domaine des tests sur des composants électroniques et concerne plus particulièrement un procédé et un dispositif de régulation de la température d'un module de pilotage d'un composant électronique. Plus particulièrement, l'invention permet de faire fonctionner un module de pilotage d'un composant électronique dans une étuve de vieillissement dudit composant ou bien dans une chambre à vide.

### ETAT DE LA TECHNIQUE

Dans le domaine de l'électronique, le taux de panne d'un composant électronique dans le temps est représenté de manière connue par une courbe en forme de U ou « de baignoire » (« bathtub curve » en langue anglaise). De manière connue, on observe ainsi que le taux de panne d'un composant est élevé en début de vie du composant et dans ce cas les pannes sont dites « de jeunesse » puis faible en milieu de vie du composant et de nouveau élevé en fin de vie du composant et dans ce dernier cas, les pannes sont dites « de vieillesse ».

Il est ainsi connu de procéder au vieillissement accéléré d'un composant électronique dans le cadre de son développement ou bien préalablement à sa commercialisation. Le vieillissement d'un composant électronique dans le cadre de son développement permet notamment de le caractériser rapidement en durée de vie (« life-test » en langue anglaise). Le vieillissement d'un composant électronique préalablement à sa commercialisation permet de mettre sur le marché un composant pré-vieilli qui a passé l'intervalle de pannes de jeunesse, cette opération étant couramment appelée « Burn-In » ou « déverminage » ou encore « rodage ».

Un procédé de vieillissement connu consiste à placer le composant électronique dans un environnement chauffé à haute température, par exemple à 125 °C, ou refroidi à une température négative, par exemple - 40°C, et de le faire fonctionner pendant un temps de vieillissement prédéterminé. Des tables de corrélation connues permettent ensuite de relier la température à un paramètre de vieillissement du composant de manière à caractériser sa durée de vie ou son comportement.

La solution de vieillissement la plus courante consiste à utiliser une étuve dans laquelle un grand nombre de composants électroniques peuvent être chauffés (ou refroidis) simultanément. Les composants électroniques sont placés sur une pluralité de cartes électroniques, se présentant sous la forme de plateaux disposés à différentes hauteurs dans l'étuve, et sont mis en fonctionnement. A cette fin, les composants électroniques sont reliés à un module d'alimentation en énergie électrique et à un module de pilotage commun à l'ensemble des composants.

Le module de pilotage (« driver » en langue anglaise) envoie des signaux au composant électronique afin de le faire fonctionner de manière nominale pendant la durée du vieillissement en étuve. Par les termes « nominal » ou « nominale », on entend dans le présent document que les capacités et les performances du composant électronique peuvent être éprouvées à partir de signaux nécessaires au fonctionnement standard du composant, i.e. selon une utilisation du composant conforme à sa fiche technique.

Afin de pouvoir fonctionner correctement et de ne pas subir le vieillissement, le module de pilotage est disposé en dehors de l'étuve et se retrouve de fait à une distance relativement importante du composant, par exemple 20 cm. Une telle distance entraîne une dégradation des signaux générés par le module de pilotage, notamment des signaux hautes-fréquences, par exemple de fréquence supérieure à 20 MHz, ce qui empêche le composant électronique de fonctionner de manière nominale et présente donc un inconvénient important.

Par ailleurs, il est également connu d'utiliser un module de pilotage pour tester un composant électronique soumis à une irradiation dans une chambre à vide placée dans un accélérateur de particules. Dans ce cas, le module de pilotage chauffe du fait de l'absence de convection dans le vide, ce qui peut provoquer son dysfonctionnement et présente donc un inconvénient important.

L'invention vise donc à résoudre cet inconvénient en proposant une solution simple, fiable et efficace pour permettre à un module de pilotage de faire fonctionner un composant électronique de manière nominale dans une étuve de vieillissement ou dans une chambre à vide.

### PRESENTATION GENERALE DE L'INVENTION

A cet effet, l'invention a pour objet un dispositif de régulation de la température d'un module de pilotage d'au moins un composant électronique destiné à être disposé à l'intérieur d'une étuve de vieillissement dudit composant électronique ou à l'intérieur d'une chambre à vide, ledit module de pilotage étant configuré pour générer des signaux électriques permettant le fonctionnement nominal du composant électronique, ledit dispositif étant configuré pour réguler la température du module de pilotage de manière à permettre son fonctionnement à l'intérieur de ladite étuve en fonctionnement tout en évitant son vieillissement prématuré ou respectivement son fonctionnement dans ladite chambre à vide avec un minimum d'échauffement voire sans échauffement.

Par les termes « permettre le fonctionnement du module de pilotage », on entend que le module de pilotage fonctionne correctement et génère des signaux électriques adaptés pour tester le fonctionnement nominal du composant électronique.

Le dispositif selon l'invention permet ainsi de maintenir la température à l'intérieur du boîtier en-dessous ou au-dessus d'une valeur seuil permettant le fonctionnement du module de pilotage dans un intervalle de températures adéquat, par exemple respectivement en-dessous de 75°C lorsque l'étuve fonctionne à haute température (par exemple plus de 100°C) ou au-dessus de 0° lorsque l'étuve fonctionne à température négative. Le module de pilotage peut ainsi être disposé dans l'étuve à proximité du composant électronique de manière à fonctionner à une température régulée garantissant que les signaux électriques reçus par le composant électronique, notamment les signaux hautes-fréquences, soient à la fois adaptés et suffisamment peu affaiblis par la distance pour faire fonctionner le composant électronique de manière nominale. De même, dans le cas d'une chambre à vide, il est nécessaire de placer le module de pilotage à proximité du composant électronique or la température du module de pilotage s'élève de manière importante dans la chambre à vide car il n'y a pas de convection dans le vide.

Une telle chambre à vide peut, par exemple, être utilisée dans le cas de tests d'irradiation dans un accélérateur de particules. Le dispositif selon l'invention permet ainsi de réduire la température du module de pilotage pour permettre son bon fonctionnement dans une chambre à vide.

Dans une forme de réalisation du dispositif selon l'invention, le dispositif comprend :
- un boîtier externe,
- un boîtier interne définissant un logement de réception du module de pilotage et s'étendant à l'intérieur dudit boîtier externe de manière à former un espace d'isolation thermique entre ledit boîtier interne et le boîtier externe, et
- un circuit de circulation d'un fluide de régulation de température aménagé à l'intérieur du boîtier externe de manière à réguler la température du module de pilotage.

Par les termes « à l'intérieur du boîtier externe », on entend que le circuit est aménagé aussi bien dans le boîtier interne que dans l'espace d'isolation thermique entre ledit boîtier interne et le boîtier externe.

Dans une forme de réalisation préférée du dispositif selon l'invention, le circuit de circulation d'un fluide de régulation de température est aménagé uniquement à l'intérieur du boîtier interne. Dans ce cas, le circuit ne chemine pas par l'espace d'isolation thermique.

De manière préférée, le circuit de circulation comprend des moyens d'entrée du fluide de régulation de température dans le boîtier externe et des moyens de sortie du fluide de régulation de température du boîtier externe.

Selon un aspect de l'invention, les moyens d'entrée et les moyens de sortie sont configurés pour être reliés, respectivement via un tuyau d'entrée et un tuyau de sortie, à des moyens de génération d'un flux de circulation de fluide tels que, par exemple, une pompe ou un conditionneur thermique de fluide, notamment pour refroidir ledit fluide.

De préférence, les moyens d'entrée comprennent au moins un tube et/ou au moins une buse d'entrée du fluide de régulation de température dans le boîtier externe.

De préférence encore, les moyens de sortie comprennent au moins un tube et/ou au moins une buse de sortie du fluide de régulation de température dans le boîtier externe.

Le fluide de régulation de température peut être un gaz, tel que par exemple de l'air ou un gaz réfrigérant, ou un liquide, tel que par exemple de l'eau ou un liquide de refroidissement ou tout fluide caloporteur.

Dans une forme de réalisation du dispositif selon l'invention, le fluide de régulation de température est sous pression, par exemple supérieure à 3 Bars.

Pour ce faire, le dispositif peut avantageusement comprendre un détendeur, se présentant par exemple sous la forme d'une vis, agencé pour modifier la pression du fluide dans le circuit de circulation ou la répartition du fluide entre plusieurs boîtiers connectés sur un même tuyau d'entrée. Ainsi, dans le cas d'un refroidissement, un réglage adéquat du détendeur permet d'utiliser le froid produit par la détente dans le boîtier pour améliorer la régulation de température.

L'espace d'isolation thermique entre le boîtier externe et le boîtier interne peut être rempli d'un fluide d'isolation thermique ou bien d'un matériau d'isolation thermique performant tel que, par exemple, un aérogel ou un élastomère, notamment de type éthylène-propylène-diène monomère (EPDM).

De manière avantageuse, le fluide d'isolation thermique provient du fluide de régulation de température. Dans ce cas, le circuit de circulation comprend au moins en partie l'espace d'isolation thermique.

Dans une forme de réalisation du dispositif selon l'invention, le dispositif comprend un échangeur de chaleur, par exemple de type Peltier connu de l'homme du métier, disposé dans le circuit de circulation.

L'invention concerne aussi un système de vieillissement d'au moins un composant électronique, ledit système comprenant :
- au moins une étuve à l'intérieur de laquelle est disposée au moins un composant électronique et au moins un dispositif de régulation de température, tel que présenté précédemment, couplé audit composant électronique et dans lequel est monté un module de pilotage dudit composant électronique, ledit module de pilotage étant relié électriquement au composant électronique et étant configuré pour générer des signaux électriques permettant le fonctionnement du composant électronique de manière nominale dans l'étuve en fonctionnement,
- des moyens de génération d'un flux de circulation d'un fluide de régulation de température connectés fluidiquement au dispositif de régulation de température de manière à générer une circulation d'un fluide de régulation de température à l'intérieur dudit dispositif.

De préférence, les moyens de génération comprennent une pompe et/ou un module de refroidissement ou de conditionnement de fluide tel que, par exemple de l'air.

Selon une caractéristique de l'invention, le système comprend un ensemble de tuyaux ou tubes permettant de connecter fluidiquement les moyens de génération au dispositif de régulation de température.

L'invention concerne également un procédé de vieillissement d'au moins un composant électronique dans une étuve, ledit composant électronique étant connecté à un module de pilotage dudit composant électronique, ledit procédé étant remarquable en ce que, le module de pilotage étant placé dans l'étuve en fonctionnement, il comprend une étape de régulation de la température du module de pilotage de manière à permettre son fonctionnement à l'intérieur de l'étuve tout en évitant son vieillissement prématuré.

L'invention concerne enfin également un système d'utilisation d'au moins un composant électronique dans le vide, ledit système comprenant :
- au moins une chambre à vide à l'intérieur de laquelle est disposée au moins un composant électronique et au moins un dispositif de régulation de température, tel que présenté précédemment, couplé audit composant électronique et dans lequel est monté un module de pilotage dudit composant électronique, ledit module de pilotage étant relié électriquement au composant électronique et étant configuré pour générer des signaux électriques permettant le fonctionnement du composant électronique de manière nominale dans la chambre à vide,
- des moyens de génération d'un flux de circulation d'un fluide de régulation de température connectés fluidiquement au dispositif de régulation de température de manière à générer une circulation d'un fluide de régulation de température à l'intérieur dudit dispositif.

De préférence, les moyens de génération comprennent une pompe et/ou un module de refroidissement ou de conditionnement de fluide tel que, par exemple de l'air.

Selon une caractéristique de l'invention, le système comprend un ensemble de tuyaux ou tubes permettant de connecter fluidiquement les moyens de génération au dispositif de régulation de température.

L'invention concerne également un procédé d'utilisation d'un composant électronique dans le vide, ledit composant électronique étant connecté à un module de pilotage dudit composant électronique, ledit procédé étant remarquable en ce que, le module de pilotage étant placé dans une chambre à vide, il comprend une étape de régulation de la température du module de pilotage de manière à permettre son fonctionnement à l'intérieur de la chambre à vide, par exemple lors d'une irradiation dans un accélérateur de particules.

D'autres caractéristiques et avantages de l'invention apparaîtront lors de la description qui suit faite en regard des figures annexées données à titre d'exemples non limitatifs et dans lesquelles des références identiques sont données à des objets semblables.

### DESCRIPTION DES FIGURES

La figure 1 représente une vue en perspective d'une forme de réalisation du système selon l'invention.
La figure 2 représente une vue en perspective d'un plateau destiné à être placé dans l'étuve du système de la figure 1.
La figure 3 représente une vue partielle en perspective et en partie éclatée du plateau de la figure 2.
La figure 4 représente une vue en perspective d'un dispositif de régulation de température selon l'invention.
La figure 5 représente une vue partielle en perspective et éclatée du dispositif de la figure 4.
La figure 6 représente une vue en perspective de dessous d'une partie du boîtier interne du dispositif de la figure 5.
La figure 7 représente une vue en coupe transversale d'une première forme de réalisation du dispositif selon l'invention.
La figure 8 représente une vue en coupe transversale d'une deuxième forme de réalisation du dispositif selon l'invention.
La figure 9 représente une vue en coupe transversale d'une troisième forme de réalisation du dispositif selon l'invention.

### DESCRIPTION DETAILLEE DE L'INVENTION

### Description d'une forme de réalisation du système selon l'invention

Le système selon l'invention permet de réaliser le vieillissement d'une pluralité de composants électroniques. Ce vieillissement peut être réalisé par chauffage, par exemple au-dessus de 100°C, ou par refroidissement, par exemple à une température négative. Le chauffage permet notamment d'user le composant électronique rapidement tandis que le refroidissement permet plus particulièrement de provoquer des fissures sur le composant électronique.

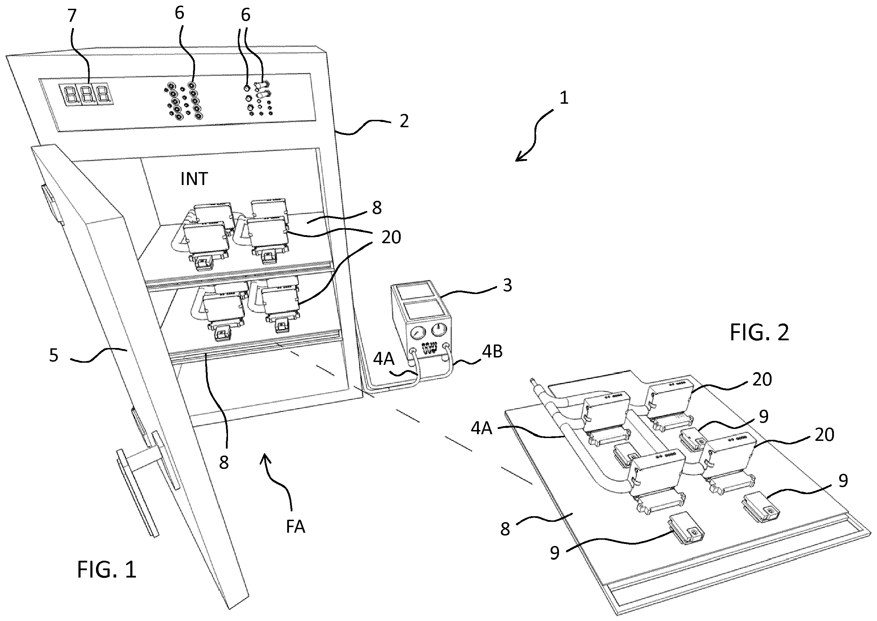

On a représenté à la figure 1 une forme de réalisation du système selon l'invention.

### Système 1

Le système 1 comprend une étuve 2 de vieillissement, des moyens de génération d'un flux de circulation de fluide et des moyens de raccordement de l'étuve aux moyens de génération d'un flux de circulation de fluide.

Dans cet exemple, en référence aux figures 1 à 3, les moyens de génération d'un flux de circulation de fluide se présentent sous la forme d'une pompe 3 et les moyens de raccordement se présentent sous la forme d'un ensemble de tuyaux d'entrée 4A de fluide, de préférence protégés de la température régnant dans l'étuve par un isolant thermique, et de tuyaux de sortie 4B de fluide permettant d'acheminer le fluide respectivement de la pompe 3 jusqu'aux dispositifs selon l'invention et des dispositifs jusqu'à la pompe 3. Par souci de clarté, on notera que seuls les tuyaux d'entrée de fluide 4A ont été représentés sur la figure 2. On notera en outre que les tuyaux de sortie sont optionnels, le fluide de régulation ayant traversé le dispositif étant alors expulsé par le flux de circulation vers l'intérieur de l'étuve.

### Etuve 2

L'étuve 2 se présente dans cet exemple sous la forme d'une armoire de forme sensiblement parallélépipédique comprenant, sur sa face avant FA (en référence à la figure 1), une porte 5, des moyens de contrôle 6 de l'étuve ainsi qu'un écran 7 d'affichage de la température de l'intérieur INT de l'étuve.

Deux plateaux 8 sont disposés à l'intérieur INT de l'étuve 2 à différentes hauteurs. Bien entendu, dans une autre forme de réalisation du système selon l'invention, le nombre de plateaux 8 pourrait être inférieur ou supérieur à deux.

Toujours en référence aux figures 1 à 3, chaque plateau 8 comprend une pluralité de supports 9 d'un composant électronique 10 et autant de connecteurs 11 femelles sur chacun desquels est monté un dispositif de régulation de température 20 selon l'invention.

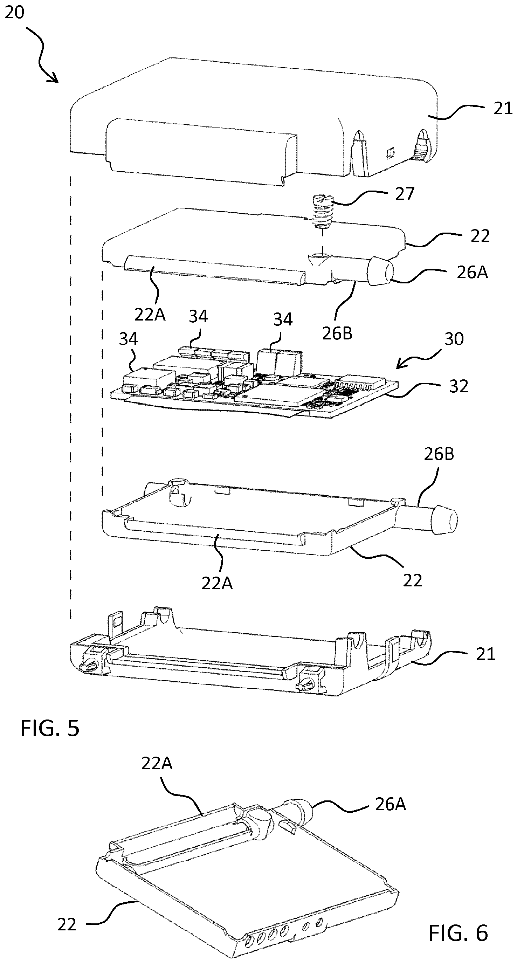

Chaque plateau 8 est une carte électronique comprenant une pluralité de circuits ou pistes électriques (non représentés), chaque circuit électrique permettant de connecter électriquement un support 9 de composant 10 au connecteur femelle 11 associé afin de permettre la transmission de signaux électriques, générés par le module de pilotage 30 (en référence à la figure 5), du dispositif 20 au composant 10 via le connecteur femelle 11 et le support 9.

A titre d'exemple, les composants électroniques 10 à faire vieillir peuvent être des microprocesseurs, des mémoires, des convertisseurs analogiques-digitaux (DAC ou ADC), des sérialiseur-désérialiseurs, des FPGA etc...

En outre, on notera que le système selon l'invention pourrait comprendre plus d'une étuve et/ou plus d'une pompe et/ou plus d'un unique composant électronique et d'un unique dispositif de régulation de température. De même, un même module de pilotage pourrait piloter une pluralité de composants électroniques. De plus, à des fins de clarté, chaque support comprend un seul composant électronique. Toutefois, il va de soi que le support pourrait comprendre une pluralité de composants électroniques.

### Dispositif 20 selon l'invention

Le dispositif 20 selon l'invention permet la régulation de la température d'un module de pilotage 30 (en référence à la figure 5) d'un composant électronique 10 disposé dans l'étuve de vieillissement 2.

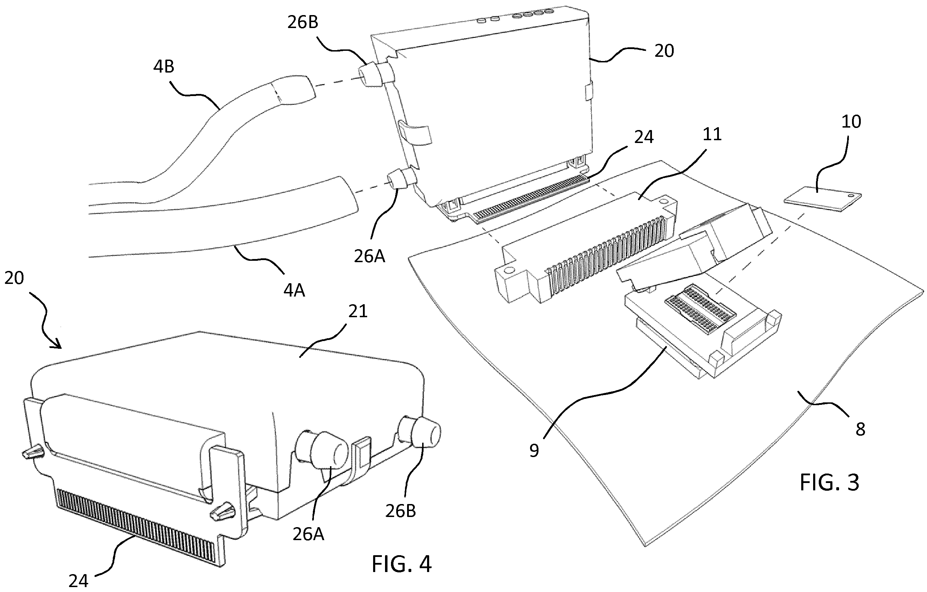

A cette fin, dans la forme de réalisation illustrée sur les figures 4 et 5, le dispositif 20 comprend un boîtier externe 21, réalisé par exemple en un matériau plastique adapté aux températures de fonctionnement de l'étuve, à l'intérieur duquel s'étend un boîtier interne 22, réalisé de préférence dans le même matériau que le boîtier externe 21.

Comme illustré à la figure 5, le boîtier externe 21 et le boîtier interne 22 présentent chacun une forme sensiblement parallélépipédique, les dimensions du boîtier interne 22 étant inférieures aux dimensions du boîtier externe 21.

Un module de pilotage 30 est monté à l'intérieur de ce boîtier interne 22. Dans cet exemple, le module de pilotage 30 se présente sous la forme d'un circuit électrique 32 sur lequel sont soudés une pluralité de composants électriques 34. Ce module de pilotage 30 est avantageusement configuré pour délivrer des signaux électriques permettant de faire fonctionner une pluralité de composants électroniques de type différent, par exemple par simple reprogrammation. Ce module de pilotage 30 ou « driver » en langue anglaise étant connu de l'homme du métier, il ne sera pas détaillé davantage ici.

Ce module de pilotage 30 permet d'envoyer des signaux électriques au composant électronique 10 associé pour le faire fonctionner de manière nominale pendant le vieillissement en étuve 2. Le fonctionnement nominal du composant électronique 10 permet notamment de tester ses capacités, ses fonctionnalités, ses performances (notamment en fréquences), sa mémoire le cas échéant etc...

Dans ce but, comme expliqué précédemment, le module de pilotage 30 est relié électriquement au composant électronique 10 associé par l'intermédiaire d'un connecteur femelle 11 sur lequel le dispositif 20 est monté, du support 9 du composant électronique 10 et du plateau 8 sur lequel le connecteur femelle 11 et le support 9 sont montés.

Afin de connecter le module de pilotage 30 au connecteur femelle 11, le dispositif 20 comprend un connecteur mâle 24 complémentaire. Le module de pilotage 30 est relié électriquement audit connecteur mâle 24 lorsqu'il est placé dans le boîtier interne 22 de manière à pouvoir transmettre des signaux électriques.

Selon l'invention, afin de permettre le bon fonctionnement du module de pilotage 30 dans l'étuve 2 à proximité du composant électronique 10 et d'en éviter le vieillissement, le dispositif 20 comprend un circuit agencé pour permettre la circulation d'un fluide F de régulation de la température du module de pilotage 30 à l'intérieur du boîtier externe 21.

Plus précisément, lorsque l'espace d'isolation thermique entre le boîtier interne et le boîtier externe est rempli par un isolant différent du fluide F de régulation thermique (par exemple de l'EPDM ou de l'aérogel), le circuit est agencé pour permettre la circulation du fluide F de régulation de la température du module de pilotage 30 à l'intérieur du boîtier interne 22.

Ce fluide F de régulation est acheminé depuis la pompe 3 par un tuyau d'entrée de fluide 4A connecté au circuit de circulation par un tube d'entrée 26A de fluide. Afin d'évacuer le fluide F, le dispositif 20 comprend en sortie du circuit de circulation un tube de sortie 26B du fluide F.

Dans cet exemple, le tube d'entrée 26A et le tube de sortie de fluide 26B sont issus de matière du boîtier interne 22. Ceci n'est toutefois en rien limitatif de la portée de la présente invention dans la mesure où le tube d'entrée 26A et le tube de sortie 26B pourraient être issus de matière du boîtier externe 21 ou bien issus de matière à la fois du boîtier externe 21 et du boîtier interne 22 ou bien encore rapportés sur le boîtier externe 21 et/ou sur le boîtier interne 22.

En référence à la figure 5, un détendeur se présentant sous la forme d'une vis 27, par exemple réalisée en un matériau plastique, est monté sur le tube d'entrée de fluide 26A de manière à régler la pression d'entrée du fluide F dans le boîtier interne 22, permettant ainsi avantageusement d'améliorer l'efficacité de la régulation de la température du module de pilotage 30.

En référence aux figures 5 et 6, le boîtier interne 22 comprend dans cet exemple une goulotte 22A permettant de diffuser le flux de fluide F sensiblement sur toute la longueur dudit boîtier interne 22 de manière à améliorer la circulation du fluide F.

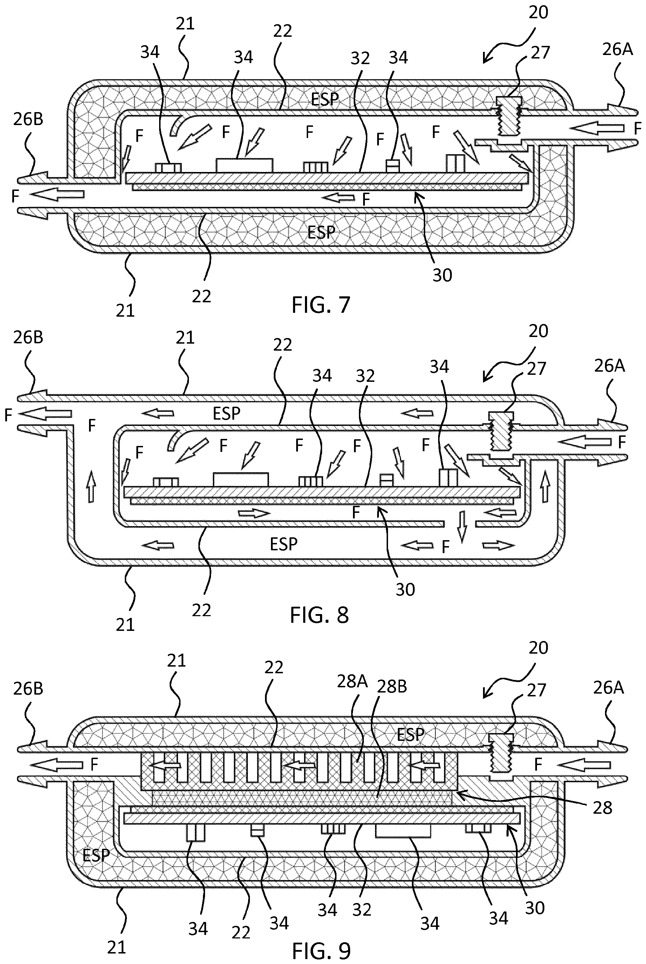

Comme illustré aux figures 7 à 9, le boîtier externe 21 et le boîtier interne 22 sont agencés de sorte à former un espace d'isolation thermique ESP.

Dans une autre forme de réalisation du dispositif selon l'invention (non représenté), le boîtier externe 21, le boîtier interne 22 et l'espace d'isolation thermique ESP peuvent être remplacés par un unique matériau dur isolant, par exemple de type céramique cellulaire à l'intérieur duquel serait placé le module de pilotage et dans lequel serait aménagé le circuit de circulation de fluide.

### Chambre à vide

Une application particulière du dispositif selon l'invention concerne son utilisation dans une chambre à vide (non représentée) et non dans une étuve. Par exemple, une telle chambre peut être utilisée dans le cadre de tests d'irradiation dans un accélérateur de particules.

Dans ce cas, le boîtier externe 21 est étanche, par exemple avec l'utilisation d'un joint de type joint en silicone. Le boîtier externe 21 est ensuite configuré pour résister à la différence de pression entre l'intérieur et l'extérieur de la chambre. A cette fin, le boîtier externe 21 peut comprendre des moyens de renforcement ou posséder des parois d'une épaisseur importante, par exemple supérieure à 3 mm. Dans le cadre de cette application, le boîtier externe 21 est ensuite de préférence réalisé en un matériau à dégazage limité dans le vide, de manière connue de l'homme du métier.

En outre, la chambre à vide est équipée de deux ouvertures, appelées « traversées » par l'homme du métier, permettant le passage des tuyaux d'entrée et de sortie du fluide de régulation, sans nécessairement que ces tuyaux soient réalisés en un matériau thermiquement isolant.

L'invention va maintenant être décrite dans sa mise en œuvre dans le cadre de son application à une étuve de vieillissement de composants électroniques.

### Mise en œuvre de l'invention

En référence aux figures 1 à 3, chaque composant électronique 10 est monté sur un support 9 et un dispositif 20 selon l'invention est monté sur le connecteur femelle 11 correspondant par l'intermédiaire du connecteur mâle 24. Le tuyau d'entrée de fluide 4A et le tuyau de sortie de fluide 4B sont alors connectés au dispositif 20 par l'intermédiaire respectivement du tube d'entrée 26A et du tube de sortie 26B. Dans cet exemple, le fluide de régulation de température est de l'air.

Les modules de pilotage 30 des dispositifs 20, l'étuve 2 et la pompe 3 sont alors mis en fonctionnement. On notera que les modules de pilotage 30 peuvent être mis en fonctionnement manuellement avant de fermer la porte 5 de l'étuve 2 ou bien à distance, par l'intermédiaire d'un câble de commande (non représenté) une fois la porte 5 fermée.

La pompe 3, éventuellement couplée à un module de conditionnement d'air (non représenté) permet de créer un flux continu d'air F (éventuellement conditionné) à l'intérieur de chaque dispositif 20 de manière à réguler la température de chacun des modules de pilotage 30 de sorte qu'ils fonctionnent correctement à une température régulée.

Dans une première forme de réalisation du dispositif selon l'invention illustrée à la figure 7, l'espace d'isolation thermique ESP est rempli d'un matériau fortement isolant, par exemple de type aérogel ou EPDM, afin d'améliorer la régulation de la température du module de pilotage 30. Le flux de fluide F circule à travers un circuit de circulation aménagé à l'intérieur du boîtier interne 22, depuis le tube d'entrée 26A, puis autour du module de pilotage 30 avant d'être éjecté par le tube de sortie 26B.

Dans une deuxième forme de réalisation du dispositif selon l'invention illustrée à la figure 8, le circuit de circulation comprend l'espace d'isolation thermique ESP qui est donc rempli du fluide F de régulation de température provenant de la pompe 3. Le flux de fluide F circule à travers un circuit de circulation, depuis le tube d'entrée 26A, puis autour du module de pilotage 30, puis dans l'espace d'isolation thermique ESP avant d'être éjecté par le tube de sortie 26B.

Dans une troisième forme de réalisation du dispositif selon l'invention illustrée à la figure 9, l'espace d'isolation thermique ESP est rempli d'un matériau isolant, par exemple de type aérogel ou EPDM, afin d'améliorer la régulation de la température du module de pilotage 30. Le flux de fluide F circule à travers un circuit de circulation aménagé à l'intérieur du boîtier interne 22, depuis le tube d'entrée 26A, puis à travers un échangeur de chaleur 28 avant d'être éjecté par le tube de sortie 26B. L'échangeur de chaleur 28 peut être de type Peltier connu de l'homme du métier. A cette fin, l'échangeur de chaleur 28 comprend un élément d'échange de chaleur 28A, par exemple de type refroidisseur en métal et un élément Peltier 28B, monté entre ledit élément d'échange de chaleur et le module de pilotage 30, au droit du module de pilotage 30 de sorte à en réguler la température.

Le procédé selon l'invention permet donc avantageusement de faire fonctionner un module de pilotage dans une étuve en fonctionnement afin de permettre le bon fonctionnement de composants électronique soumis à un procédé de vieillissement.

Il est à noter enfin que la présente invention n'est pas limitée aux exemples décrits ci-dessus et est susceptible de nombreuses variantes accessibles à l'homme de l'art. Notamment, le nombre, la forme et les dimensions de l'étuve 2, de la pompe 3 et du dispositif 20, tels que représentés sur les figures de façon à illustrer un exemple de réalisation de l'invention, ne sauraient être interprétés comme limitatifs.

## Revendications

1. Dispositif (20) de régulation de la température d'un module de pilotage (30) d'au moins un composant électronique (10) destiné à être disposé à l'intérieur (INT) d'une étuve (2) de vieillissement dudit composant électronique (10) ou d'une chambre à vide, ledit module de pilotage (30) étant configuré pour générer des signaux électriques permettant le fonctionnement nominal du composant électronique (10), ledit dispositif (20) étant configuré pour réguler la température du module de pilotage (30) de manière à permettre son fonctionnement à l'intérieur (INT) de ladite étuve en fonctionnement tout en évitant son vieillissement prématuré ou respectivement son fonctionnement à l'intérieur de ladite chambre à vide.

2. Dispositif selon la revendication 1, ledit dispositif comprenant :
- un boîtier externe (21),
- un boîtier interne (22) définissant un logement de réception du module de pilotage (30) et s'étendant à l'intérieur dudit boîtier externe (21) de manière à former un espace d'isolation thermique (ESP) entre ledit boîtier interne (22) et le boîtier externe (21), et
- un circuit de circulation d'un fluide (F) de régulation de température aménagé à l'intérieur du boîtier externe (21) de manière à réguler la température du module de pilotage (30).

3. Dispositif selon la revendication précédente, le circuit de circulation d'un fluide (F) de régulation de température est aménagé uniquement à l'intérieur du boîtier interne (22).

4. Dispositif selon l'une des revendications 2 et 3, dans lequel le circuit de circulation comprend des moyens d'entrée (26A) du fluide (F) de régulation de température dans le boîtier externe (21) et des moyens de sortie (26B) du fluide (F) de régulation de température du boîtier externe (21).

5. Dispositif selon l'une des revendications 2 à 4, ledit dispositif comprenant un détendeur (27) agencé pour modifier la pression du fluide (F) dans le circuit de circulation.

6. Dispositif selon l'une des revendications 2 à 5, dans lequel l'espace d'isolation thermique (ESP) entre le boîtier externe (21) et le boîtier interne (22) est rempli d'un fluide d'isolation thermique.

7. Dispositif selon la revendication précédente, dans lequel le fluide d'isolation thermique provient du fluide (F) de régulation de température.

8. Dispositif selon l'une des revendications 2 à 5, dans lequel l'espace d'isolation thermique (ESP) entre le boîtier externe (21) et le boîtier interne (22) est rempli d'un matériau d'isolation thermique.

9. Dispositif selon la revendication précédente, dans lequel le matériau d'isolation thermique est un aérogel ou un élastomère.

10. Dispositif selon la revendication précédente, dans lequel le matériau d'isolation thermique est de type éthylène-propylène-diène monomère (EPDM).

11. Dispositif selon l'une des revendications 2 à 10, ledit dispositif comprenant un échangeur de chaleur (28), par exemple de type Peltier, disposé dans le circuit de circulation.

12. Système (1) de vieillissement d'au moins un composant électronique (10), ledit système (1) comprenant :
- au moins une étuve (2) à l'intérieur de laquelle est disposée au moins un composant électronique (10) et au moins un dispositif (20) de régulation de température, selon l'une des revendications précédentes, couplé audit composant électronique (10) et dans lequel est monté un module de pilotage (30) dudit composant électronique (10), ledit module de pilotage (30) étant relié électriquement au composant électronique (10) et étant configuré pour générer des signaux électriques permettant le fonctionnement du composant électronique (10) de manière nominale dans l'étuve (2) en fonctionnement,
- des moyens de génération d'un flux de circulation d'un fluide (F) de régulation de température connectés fluidiquement au dispositif de régulation de température (20) de manière à générer une circulation d'un fluide (F) de régulation de température à l'intérieur dudit dispositif (20).

13. Système selon la revendication précédente, dans lequel les moyens de génération comprennent une pompe (3).

14. Système selon l'une des revendications précédentes 12 et 13, comprenant un ensemble de tuyaux ou tubes permettant de connecter fluidiquement les moyens de génération au dispositif de régulation de température.

15. Procédé de vieillissement d'un composant électronique (10) dans une étuve (2), ledit composant électronique (10) étant connecté à un module de pilotage (30) dudit composant électronique (10), ledit procédé étant **caractérisé en ce que**, le module de pilotage (30) étant placé dans l'étuve (2) en fonctionnement, il comprend une étape de régulation de la température du module de pilotage (30) de manière à permettre son fonctionnement à l'intérieur (INT) de l'étuve (2) tout en évitant son vieillissement.

## Patentansprüche

1. Vorrichtung (20) zur Regulierung der Temperatur eines Steuermoduls (30) mindestens einer elektronischen Komponente (10), die bestimmt ist, im Inneren (INT) eines Alterungsschranks (2) der elektronischen Komponente (10) oder einer Vakuumkammer angeordnet zu sein, wobei das Steuermodul (30) konfiguriert ist, um elektrische Signale zu erzeugen, welche den Nominalbetrieb der elektronischen Komponente (10) gestatten, wobei die Vorrichtung (20) konfiguriert ist, um die Temperatur des Steuermoduls (30) derart zu regulieren, dass sein Betrieb im Inneren (INT) des Schranks in Betrieb bei Vermeidung seiner vorzeitigen Alterung oder beziehungsweise sein Betrieb im Inneren der Vakuumkammer gestattet ist.

2. Vorrichtung nach Anspruch 1, wobei die Vorrichtung umfasst:
- ein äußeres Gehäuse (21),
- ein inneres Gehäuse (22), das eine Empfangsaufnahme des Steuermoduls (30) definiert und sich im Inneren des äußeren Gehäuses (21) derart erstreckt, dass ein Wärmeisolationsraum (ESP) zwischen dem inneren Gehäuse (22) und dem äußeren Gehäuse (21) gebildet wird, und
- einen Zirkulationskreis eines Fluids (F) zur Regulierung der Temperatur, der im Inneren des äußeren Gehäuses (21) derart eingerichtet ist, dass die Temperatur des Steuermoduls (30) reguliert wird.

3. Vorrichtung nach vorangehendem Anspruch, wobei der Zirkulationskreis eines Fluids (F) zur Regulierung der Temperatur nur im Inneren des inneren Gehäuses (22) eingerichtet ist.

4. Vorrichtung nach einem der Ansprüche 2 und 3, wobei der Zirkulationskreis Einlassmittel (26A) des Fluids (F) zur Regulierung der Temperatur in das äußere Gehäuse (21) und Auslassmittel (26B) des Fluids (F) zur Regulierung der Temperatur aus dem äußeren Gehäuse (21) umfasst.

5. Vorrichtung nach einem der Ansprüche 2 bis 4, wobei die Vorrichtung einen Druckregler (27) umfasst, der ausgebildet ist, um den Druck des Fluids (F) in dem Zirkulationskreis zu ändern.

6. Vorrichtung nach einem der Ansprüche 2 bis 5, wobei der Wärmeisolationsraum (ESP) zwischen dem äußeren Gehäuse (21) und dem inneren Gehäuse (22) mit einem Wärmeisolationsfluid gefüllt ist.

7. Vorrichtung nach vorangehendem Anspruch, wobei das Wärmeisolationsfluid vom Fluid (F) zur Regulierung der Temperatur kommt.

8. Vorrichtung nach einem der Ansprüche 2 bis 5, wobei der Wärmeisolationsraum (ESP) zwischen dem äußeren Gehäuse (21) und dem inneren Gehäuse (22) mit einem Wärmeisolationsmaterial gefüllt ist.

9. Vorrichtung nach vorangehendem Anspruch, wobei das Wärmeisolationsmaterial ein Aerogel oder ein Elastomer ist.

10. Vorrichtung nach vorangehendem Anspruch, wobei das Wärmeisolationsmaterial vom Typ Ethylen-Propylen-Dien-Monomer (EPDM) ist.

11. Vorrichtung nach einem der Ansprüche 2 bis 10, wobei die Vorrichtung einen Wärmetauscher (28) umfasst, beispielsweise vom Typ Peltier, der in dem Zirkulationskreis angeordnet ist.

12. System (1) zur Alterung mindestens einer elektronischen Komponente (10), wobei das System (1) umfasst:
- mindestens einen Schrank (2), in dessen Inneren mindestens eine elektronische Komponente (10) und mindestens eine Vorrichtung (20) zur Regulierung der Temperatur nach einem der vorangehenden Ansprüche angeordnet ist, gekoppelt an die elektronische Komponente (10), und in dem ein Steuermodul (30) der elektronischen Komponente (10) angebracht ist, wobei das Steuermodul (30) mit der elektronischen Komponente (10) elektrisch verbunden und konfiguriert ist, um elektrische Signale zu erzeugen, die den nominalen Betrieb der elektronischen Komponente (10) im Schrank (2) in Betrieb gestatten,
- Mittel zum Erzeugen eines Zirkulationsstroms eines Fluids (F) zur Regulierung der Temperatur, die derart fluidisch an die Vorrichtung zur Regulierung der Temperatur (20) angeschlossen sind, dass eine Zirkulation eines Fluids (F) zur Regulierung der Temperatur im Inneren der Vorrichtung (20) erzeugt wird.

13. System nach vorangehendem Anspruch, wobei die Erzeugungsmittel eine Pumpe (3) umfassen.

14. System nach einem der vorangehenden Ansprüche 12 und 13, umfassend eine Einheit von Rohren oder Schläuchen, die erlauben, die Erzeugungsmittel an die Vorrichtung zur Regulierung der Temperatur fluidisch anzuschließen.

15. Verfahren zur Alterung einer elektronischen Komponente (10) in einem Schrank (2), wobei die elektronische Komponente (10) an ein Steuermodul (30) der elektronischen Komponente (10) angeschlossen ist, wobei das Verfahren **dadurch gekennzeichnet ist, dass**, wobei das Steuermodul (30) in dem Schrank (2) in Betrieb platziert ist, es einen Schritt zur Regulierung der Temperatur des Steuermoduls (30) derart umfasst, dass sein Betrieb im Inneren (INT) des Schranks (2) bei Vermeidung seiner Alterung gestattet ist.

## Claims

1. A device (20) for regulating the temperature of a driving module (30) of at least one electronic component (10) meant to be disposed inside (INT) an oven (2) for aging said electronic component (10) or a vacuum chamber, said driving module (30) being configured to generate electric signals enabling the nominal operation of the electronic component (10), said device (20) being configured to regulate the temperature of the driving module (30) so as to enable its operation inside (INT) said oven in use while avoiding its premature aging or respectively its operation inside said vacuum chamber.

2. The device according to claim 1, said device comprising:
- an outer casing (21),
- an inner casing (22) defining a housing for receiving the driving module (30) and extending inside said outer casing (21) so as to form a heat insulative space (ESP) between said inner casing (22) and the outer casing (21), and
- a circulation circuit for a temperature regulating fluid (F) provided inside the outer casing (21) so as to regulate the temperature of the driving module (30).

3. The device according to the preceding claim, the circulation circuit for a temperature regulating fluid (F) being provided only inside the inner casing (22).

4. The device according to one of claims 2 and 3, wherein the circulation circuit comprises inlet means (26A) for the temperature regulating fluid (F) in the outer casing (21) and outlet means (26B) for the temperature regulating fluid (F) from the outer casing (21).

5. The device according to one of claims 2 to 4, said device comprising a pressure reducer (27) arranged to modify the pressure of the fluid (F) in the circulation circuit.

6. The device according to one of claims 2 to 5, wherein the heat insulative space (ESP) between the outer casing (21) and the inner casing (22) is filled with a heat insulative fluid.

7. The device according to the preceding claim, wherein the heat insulative fluid comes from the temperature regulating fluid (F).

8. The device according to one of claims 2 to 5, wherein the heat insulative space (ESP) between the outer casing (21) and the inner casing (22) is filled with a heat insulative material.

9. The device according to the preceding claim, wherein the heat insulative material is an aerogel or an elastomer.

10. The device according to the preceding claim, wherein the heat insulative material is of the ethylene-propylene-diene monomer (EPDM) type.

11. The device according to one of claims 2 to 10, said device comprising a heat exchanger (28), for example of the Peltier type, disposed in the circulation circuit.

12. A system (1) for aging at least one electronic component (10), said system (1) comprising:
- at least one oven (2) inside which at least one electronic component (10) and at least one temperature regulating device (20) are disposed, according to any of the preceding claims, which device is coupled to said electronic component (10) and wherein a driving module (30) for said electronic component (10) is mounted, said driving module (30) being electrically connected to the electronic component (10) and being configured to generate electric signals enabling the operation of the electronic component (10) in a nominal way in the oven (2) in use,
- means for generating a circulation flow of a temperature regulating fluid (F) which are fluidly connected to the temperature regulating device (20) so as to generate a circulation of a temperature regulating fluid (F) inside said device (20).

13. The system according to the preceding claim, wherein the generation means comprise a pump (3).

14. The system according to one of the preceding claims 12 and 13, comprising a set of hoses or tubes enabling the generation means to be fluidly connected to the temperature regulating device.

15. A method for aging an electronic component (10) in an oven (2), said electronic component (10) being connected to a driving module (30) of said electronic component (10), said method being **characterised in that**, the driving module (30) being placed in the oven (2) in use, it comprises a step of regulating the temperature of the driving module (30) so as to enable its operation inside (INT) the oven (2) while avoiding its aging.
